# EUROPEAN PATENT APPLICATION

(11) **EP 1 734 573 A1**
(43) Date of publication of application: **20.12.2006**
(21) Application number: 06011689.4
(22) Date of filing: 06.06.2006
(51) Int. Cl.: H01L 21/673, H01L 21/677, H01L 21/68, B65D 85/38, F16B 1/00

(54) **Thin-plate supporting container**

(30) Priority: 13.06.2005 JP 2005172441
(71) Applicant: Miraial Co., Ltd., Tokyo (JP)
(72) Inventor: Obayashi, Tadahiro, Shisui-machi Kikuchi-shi Kumamoto-ken (JP); Emura, Yoichi, Shisui-machi Kikuchi-shi Kumamoto-ken (JP)
(74) Representative: Grünecker, Kinkeldey, Stockmair & Schwanhäusser Anwaltssozietät

(57) **Abstract**

When a thin-plate supporting container (21) is placed on a placement table, a misplacement can be corrected so that the thin-plate supporting container (21) is always precisely positioned. The thin-plate supporting container (21) includes a container body (22) for housing therein a semiconductor wafer and the like and positioning means (23) provided to the container body (22) for positioning the container body (22) at a set position on a placement table to place the container body (22) on the placement table and take a semiconductor wafer and the like into and out of the container body (22). The positioning means (23) includes an engagement groove (24) for engaging an engagement protrusion provided on the placement table, and an inclined plane (25) to be in contact with the engagement protrusion in a state wherein the engagement groove (24) engages with the engagement protrusion. The inclined plane (25) is embossed so as to reduce a contact area with the engagement protrusion to decrease the friction resistance therebetween.

## Description

### BACKGROUND OF THE INVENTION

### 1. Field of the Invention

The present invention relates to a thin-plate supporting container which has positioning means for positioning a placement table to a set position in order to take in and out thin plates.

### 2. Description of the Related Art

A thin-plate supporting container used for automatically taking in and out an internal semiconductor wafer and the like is generally known. In such thin-plate supporting container, in order to align a position of an arm of a transfer device and a position of a semiconductor wafer and the like, positioning means is provided. As an example of the thin-plate supporting container equipped with the positioning means, a thin-plate supporting container disclosed in WO 99/39994 is known. With reference to Figs. 2 to 4, the thin-plate supporting container will be described.

A thin-plate supporting container 1 shown in the drawings has a container body 2 which houses therein a plurality of semiconductor wafers (not shown), two thin-plate supporting parts (not shown) each provided on opposing side walls of the container body 2 respectively for supporting the semiconductor wafers housed in the container body 2 from the both sides of the wafers, a lid 4 for covering an opening 2F of the container body 2, a top flange 5 which is supported by an arm of a transfer device (not shown) if necessary, and a carrying handle 6 which is gripped by an operator when he carries the thin-plate supporting container 1 by hand.

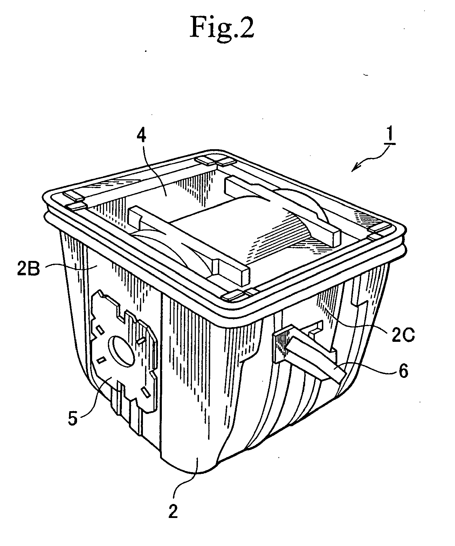

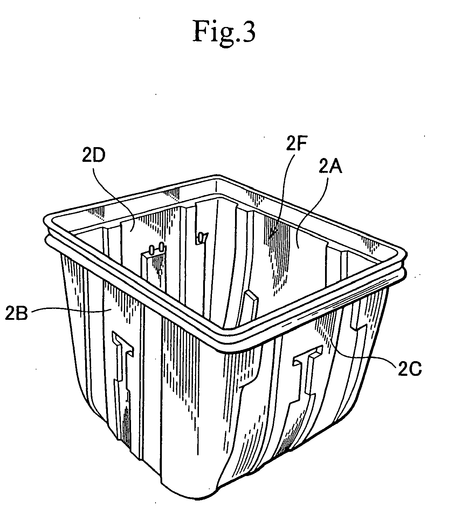

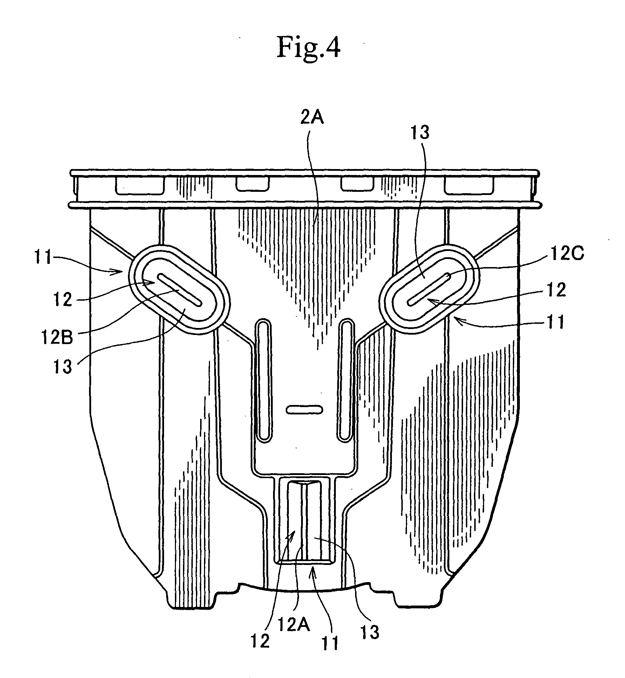

The container body 2 is formed substantially in the shape of a cube as a whole. The container body is, in an upright position (in the state shown in Figs. 2 to 4), composed of four side walls 2A, 2B, 2C, and 2D to be circumferential walls, and a bottom part (not shown), and the opening 2F is provided on top of the container body 2. The container body 2 is placed in a horizontal position when the container body 2 is placed opposite to a wafer transferring robot (not shown) in a semiconductor wafer manufacturing line or the like. In the horizontal state, positioning means 11 which positions the thin-plate supporting container 1 is provided to the outside of the side wall 2A which functions as a bottom part. The top flange 5 is detachably mounted to the outside of the side wall 2B which functions as a top part in the horizontal state. The carrying handle 6 is detachably mounted to the outside of the side walls 2C and 2D which function as side parts in the horizontal state.

The positioning means 11 is provided to the side wall 2A. The positioning means 11 is composed mainly of three engagement grooves 12. Each of the engagement grooves 12 has a first engagement groove 12A which aligns with the vertical direction of the container body 2, and a second groove 12B and a third groove 12C both of which are inclined at the same angle (approximately 60 degrees) to the vertical direction of the container body 2. These three engagement grooves 12 are finished at high precision to meet their standard. Each of the engagement grooves 12A, 12B, and 12C has an inclined plane 13 as an inner wall, and the inner wall 13 is configured to be directly in contact with an engagement protrusion (not shown) of a placement table side. By each of the engagement grooves 12A, 12B, and 12C engaging with each of engagement protrusion of the placement table side, the inclined plane 13 is in contact with the engagement protrusion and slides, and each central position of each of the engagement grooves 12A, 12B, and 12C aligns at the central position of the each engagement protrusion. With the alignment of the central position of each of the engagement grooves 12A, 12B, and 12C with each central position of engagement protrusion, the thin-plate supporting container 1 is set at an exact location, an arm part of the wafer transferring robot supports a semiconductor wafer and takes the semiconductor wafer in and out.

In the thin-plate supporting container, each inclined plane 13 of each of the engagement grooves 12A, 12B, and 12C is formed in a flat plane. Accordingly, a contact area between the inclined plane 13 and the engagement protrusion of the placement table side becomes large.

Meanwhile, some construction materials of the thin-plate supporting container, such as polycarbonate, have a large friction resistance. Accordingly, as the contact area between the inclined plane 13 and the engagement protrusion of the placement table side becomes large, the friction resistance becomes larger. As a result, the inclined plane 13 and the engagement protrusion of the placement table side become hard to slide, sometimes it is hard to readily position the thin-plate supporting container.

### SUMMARY OF THE INVENTION

The present invention has been made to solve the above drawbacks. It is an object of the present invention to provide a thin-plate supporting container capable of readily and precisely perform positioning.

It is another aspect of the present invention to provide a thin-plate supporting container having a container body for housing therein a thin-plate, and positioning means provided to the container body for positioning the container body at a set position on a placement table to place the container body on the placement table and take in and out the internal thin-plate. The positioning means includes an engagement groove for engaging an engagement protrusion provided on the placement table, and a inclined plane to be in contact with the engagement protrusion in a state the engagement groove engages with the engagement protrusion, and the inclined plane is treated so that friction resistance is reduced.

Preferably, the inclined plane of the engagement groove in the positioning means is subjected to embossing formed by shot peening and sandblasting and the like, so as to reduce a contact area of the inclined plane and the engagement protrusion to reduce the friction resistance.

Since the inclined plane of the engagement groove in the positioning means is treated so as to reduce the friction resistance by embossing, and the like, if the engagement groove in the positioning means is fit to the engagement protrusion, the inclined plane of the engagement groove in the positioning means smoothly slide against the engagement protrusion and the precise positioning of the thin-plate supporting container is enabled.

### BRIEF DESCRIPTION OF THE DRAWINGS

Fig. 1 is an elevational view of a thin-plate supporting container according to an embodiment of the present invention;
Fig. 2 is a perspective view showing a conventional thin-plate supporting container;
Fig. 3 is a perspective view showing the conventional thin-plate supporting container in a state in which the lid is removed; and
Fig. 4 is an elevational view of the conventional thin-plate supporting container.

### DESCRIPTION OF THE PREFERRED EMBODIMENTS

Hereinafter, a thin-plate supporting container according to embodiments of the present invention will be described with reference to the attached drawings.

The thin-plate supporting container according to embodiments of the present invention is preferably used as a container for housing, storing, and transporting a thin-plate such as a semiconductor wafer, a storage disk, a liquid crystal glass substrate, and the like. In this embodiment, a thin-plate supporting container for housing a semiconductor wafer will be described. The overall structure of the thin-plate supporting container according to this embodiment is substantially similar to that of the above-described conventional thin-plate supporting container. Hereinafter, the description will be schematically made.

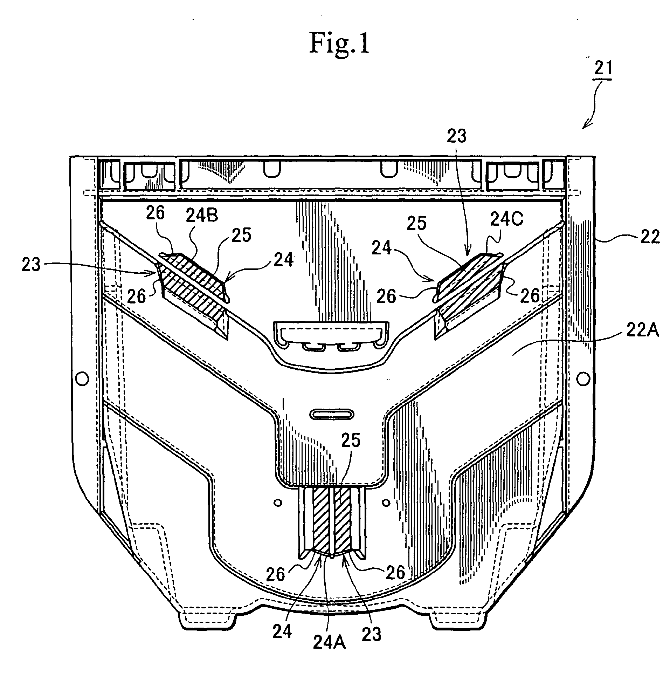

As shown in Fig. 1, a thin-plate supporting container 21 according to this embodiment mainly includes a container body 22 for housing therein a plurality of semiconductor wafers (not shown), two thin-plate supporting parts (not shown) provided in the container body 22 each provided opposite to each other for supporting the semiconductor wafers, and a lid (not shown) for covering the container body 22.

The container body 22 is structured substantially similar in the overall shape to the container body 2 of the conventional thin-plate supporting container 1. To the outside of a side wall 22A which functions as a bottom part in a horizontally-placed state, positioning means 23 of the thin-plate supporting container 21 is provided.

The positioning means 23 is provided to the side wall 22A. The positioning means 23 is composed mainly of three engagement grooves 24. The engagement grooves 24 have a first engagement groove 24A which aligns with the vertical direction of the container body 22, and a second groove 24B and a third groove 24C both of which are inclined at the same angle (approximately 60 degrees) to the vertical direction of the container body 22. The three engagement grooves 24A, 24B and 24C are finished at high precision to meet their standard. Each engagement grooves 24A, 24B and 24C is configured to engage with an engagement protrusion (not shown) of the placement table side, and has an inclined plane 25 as an inner wall. The inclined plane 25 is configured to be directly in contact with the engagement protrusion of the placement table. Each engagement grove 24 has an inclined plate 26 which is integrally provided on the surface of the side wall part 22A. By placing two inclined plates 26 so as to opposite each other, each engagement groove 24 and each inclined plane 25 is structured. The inclined plate 26 has elasticity, and sags in some degree by being contact with the engagement protrusion of the placement table.

The surface of the inclined plane 25 is treated in order to reduce the contact area so that the friction resistance is reduced. In particular, the surface of the inclined plane 25 is subject to embossing in order to reduce the friction resistance. It can also be possible to drawn the surface of the inclined plane 25 to be in a concave-convex state such as a stain finished surface, or form numerous fine grooves. In the case in which the numerous fine grooves are formed, the grooves should be formed in a direction that the engagement groove displaces along the inclined plane 25. Further, on the surface of the inclined plane 25, fine grooves which are vertical in the ridge line direction and have a cross section of arc shape, triangular shape, or trapezoidal shape, can be regularly or irregularly formed. Further, protrusions of hemispheric shape, cone shape, or truncated trapezoidal shape, can be regularly or irregularly formed. Further, grooves and protrusions of each shape can be appropriately combined.

### [Operation]

Thus structured thin-plate supporting container 21 is used as described below.

When a semiconductor wafer is automatically taken in and out to the thin-plate supporting container 21, the thin-plate supporting container 21 is placed on the placement table. Then, the positioning means 23 of the container body 22 is fit to the engagement protrusion on the placement table. In particular, the engagement groove 24 is fit to the engagement protrusion and the inclined plane 25 is in contact with the engagement protrusion.

Then, when the thin-plate supporting container 21 is placed in a state displaced from a set position, the engagement protrusion is displaced against the inclined plane 25. And when the thin-plate supporting container 21 is placed on the placement table in the displaced state, due to the weight of the thin-plate supporting container 21, the inclined plane 25 smoothly slides against the engagement protrusion and corrects the displacement, and displaces the engagement groove 24 to the precise position. Then, the inclined plate 26 is elastically sagged, preventing the friction resistance from increasing too much due to the pressure increased more than necessary at the contact portion of the inclined plane 25 and the engagement protrusion, and a smooth slide against the engagement protrusion of the inclined plane 25 is ensured. Thus, the slide of the inclined plane 25 against the engagement protrusion occurs at the three engagement grooves 24A, 24B, and 24C respectively, and the thin-plate supporting container 21 is precisely positioned.

Then, an arm part of the wafer transferring robot supports the semiconductor wafer and takes in and out the semiconductor wafer to the thin-plate supporting container 21.

### [Advantages]

As described above, the inclined plane 25 of the engagement groove 24 in the positioning means 23 is treated so as to reduce the friction resistance by embossing, and the like, when the inclined plane 25 of the engagement groove 24 is fit to the engagement protrusion of the placement table, the inclined plane 25 and the engagement protrusion smoothly slide and the precise and easy positioning of the thin-plate supporting container is enabled.

Further, since the inclined plane 25 is composed of the inclined plate 26 which can be elastically sagged, even if the pressure increases more than necessary at the contact portion of the inclined plane 25 and the engagement protrusion, the inclined plate 26 is elastically sagged. Accordingly, the friction resistance is prevented from increasing too much, and the smooth slide against the engagement protrusion of the inclined plane 25 is ensured. As a result, it is possible to precisely position the thin-plate supporting container.

## Claims

1. A thin-plate supporting container comprising:
a container body for housing therein a thin-plate; and
positioning means provided to the container body for positioning the container body at a set position on a placement table to place the container body on the placement table and take in and out the internal thin-plate;
wherein the positioning means includes an engagement groove for engaging an engagement protrusion provided on the placement table, and a inclined plane to be in contact with the engagement protrusion in a state the engagement groove engages with the engagement protrusion, and the inclined plane is treated so that friction resistance is reduced.

2. The thin-plate supporting container according to Claim 1, wherein the inclined plane of the engagement groove in the positioning means is treated so as to reduce a contact area of the inclined plane and the engagement protrusion to decrease the friction resistance.

3. The thin-plate supporting container according to Claim 1, wherein the inclined plane of the engagement groove in the positioning means is treated so as to reduce the friction resistance by embossing.
